Europäisches Patentamt

European Patent Office

Office européen des brevets

(19)

(11) **EP 0 515 291 B1**

(12)

# FASCICULE DE BREVET EUROPEEN

(45) Date de publication et mention
de la délivrance du brevet:
**22.01.1997   Bulletin 1997/04**

(51) Int Cl.6: **G01R 27/18**, G01R 19/25

(21) Numéro de dépôt: **92420160.1**

(22) Date de dépôt: **15.05.1992**

(54) **Chaine de traitement de grandeurs de mesure pour contrôleur d'isolement numerique**

Kette zur Messwertaufbereitung für ein numerisches Isolationsüberwachungsgerät

Signal conditioning circuit arrangement for digital insulation controller

(84) Etats contractants désignés:
**BE CH DE ES GB IT LI SE**

(30) Priorité: **21.05.1991 FR 9106308**

(43) Date de publication de la demande:
**25.11.1992   Bulletin 1992/48**

(73) Titulaire: **SCHNEIDER ELECTRIC SA
92100 Boulogne Billancourt (FR)**

(72) Inventeurs:
 • **Forveil, Roger
 F-38050 Grenoble Cedex 9 (FR)**
 • **Vincent, François
 F-38050 Grenoble Cedex 9 (FR)**

(74) Mandataire: **Hecké, Gérard et al
Schneider Electric SA,
Sce. Propriété Industrielle
38050 Grenoble Cédex 09 (FR)**

(56) Documents cités:
 **EP-A- 0 074 235       EP-A- 0 399 923**

 • **U.TIETZE, CH. SCHENK
 'HALBLEITER-SCHALTUNGSTECHNIK' 1986 ,
 SPRINGER , BERLIN HEIDELBERG NEW YORK
 LONDON PARIS TOKYO**
 • **1987 IEEE REGION 5 CONFERENCE,
 "ELECTRICAL ENGINEERING, CHALLENGES IN
 THE 1990'S", MARCH 9-11, 1987, NEW YORK,
 US; M.E. PARTEN ET AL.: "A DIGITAL
 VOLTMETER PERIPHERAL FOR A
 MICROCOMPUTER", PAGES 189 - 192**

Remarques:
Le dossier contient des informations techniques
présentées postérieurement au dépôt de la
demande et ne figurant pas dans le présent
fascicule.

## Description

La présente invention se rapporte à une chaîne de traitement de grandeurs de mesure pour contrôleur d'isolement numérique, cette chaîne de traitement utilisant, pour la détermination des composantes de ces grandeurs de mesure, une démodulation ou détection synchrone.

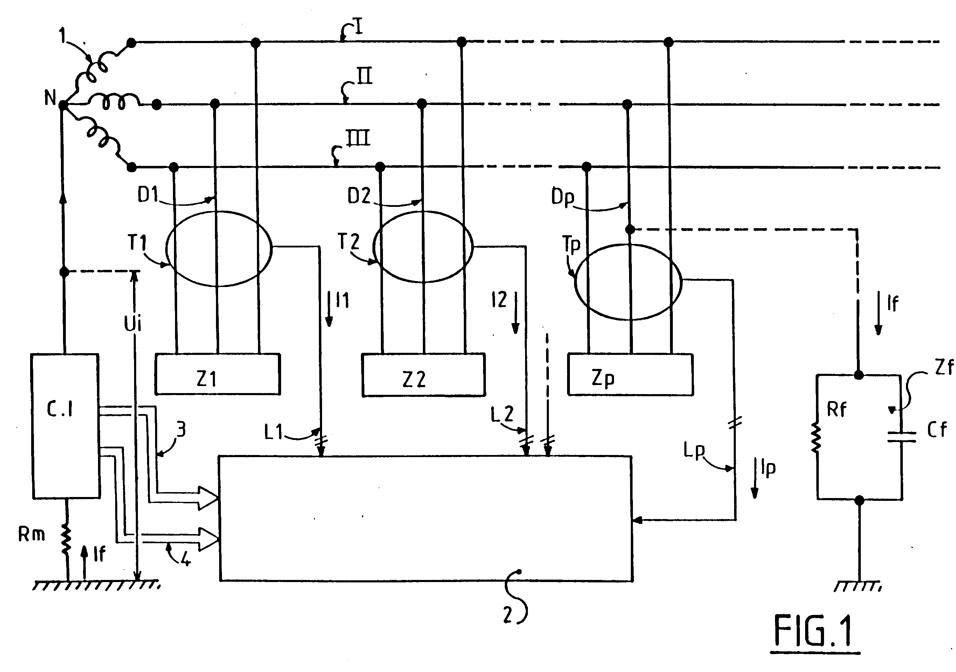

Un contrôleur d'isolement numérique de ce type est par exemple décrit dans le document FR-A-2.647.220 de la demanderesse, mais un dispositif encore plus perfectionné est représenté sur la figure 1 jointe, et son fonctionnement est globalement le suivant:

Un transformateur d'alimentation triphasé 1, en montage étoile avec neutre isolé N, alimente en énergie électrique alternative les trois barres de distribution I,II, III du réseau ou secteur qui alimente lui-même en énergie électrique plusieurs impédances d'utilisation Z1,Z2,...,Zp,..., celles-ci étant respectivement branchées sur un même nombre de dérivations triphasées D1,D2,...,Dp,..., du réseau principal de distribution.

Il est supposé qu'une des impédances de charge, par exemple l'impédance Zp, présente un défaut d'isolement par rapport à la terre qui se traduit par la présence, entre au moins un des trois fils de phase de la dérivation correspondante Dp et la terre, d'une impédance de fuite Zf constituée d'une résistance de fuite Rf en parallèle avec une capacité de fuite Cf.

Pour détecter et mesurer ce défaut, un contrôleur d'isolement C.I., qui est branché entre le neutre isolé N et la terre en série avec une résistance de mesure Rm, injecte sur le réseau, une tension alternative dite "de référence", de tension Ui et de fréquence inférieure à celle du courant alternatif d'alimentation, cette fréquence injectée étant par exemple comprise entre 4 et 10 Hertz pour un réseau alternatif à 50 ou 60 Hertz.

La présence du défaut d'isolement entraîne, suite à l'injection sur le réseau de la tension de référence Ui, la circulation d'un courant de fuite If dans l'impédance de fuite Zf, ce courant If étant bien entendu à la fréquence de la tension injectée Ui et se rebouclant vers le contrôleur d'isolement C.I à travers la terre et la résistance de mesure Rm.

Le contrôleur d'isolement C.I. génère lui-même par ailleurs une sinusoïde et une cosinusoïde auxiliaires qui lui permettent, par un procédé classique dit de démodulation ou détection synchrone, de déterminer les deux composantes, prises selon les mêmes axes de référence, réelle et imaginaire des vecteurs représentatifs de la tension injectée Ui et du courant de fuite If (c'est à dire en fait du courant injecté). De ces composantes, il déduit la différence de phases entre ces vecteurs Ui et If, et de là les valeurs de la résistance de fuite Rf et de la capacité de fuite Cf.

Le contrôleur d'isolement C.I. détermine et mesure un défaut d'isolement qui se produit quelque part sur le réseau. Le dispositif selon la figure 1 est en outre équipé de moyens pour localiser et mesurer localement tout défaut d'isolement.

Dans ce but, un transformateur de mesure d'intensité à tore, respectivement T1,T2,...,Tp,..., est placé autour de chacune des dérivations précitées D1,D2,..., Dp,...Le signal de mesure d'intensité qui est délivré par chacun des transformateurs T1 à Tp est appliqué, via une ligne bifilaire L1,L2,...,Lp,..., à un ensemble de traitement et de calcul 2 appelé "localisateur".

Essentiellement, le localisateur 2 comporte un processeur central et des chaînes de mesure, d'acquisition, et de traitement numérique qui sont pratiquement identiques à celles du contrôleur global d'isolement C.I.

Le localisateur 2 effectue la démodulation synchrone du ou des courants de mesure I1, et/ou I2,... et/ou Ip,...,qui parcourent la ou les liaisons bifilaires L1, et/ou L2,..., et/ou Lp,..., au moyen d'une sinusoïde et d'une cosinusoïde de référence générées par lui-même, et ayant la même fréquence que celles générées par le contrôleur d'isolement global C.I.

La démodulation synchrone effectuée par le localisateur 2 permet d'obtenir les composantes réelle et imaginaire du courant de fuite dans la ou les dérivations où une telle fuite existe. Le localisateur 2 permet également de localiser la dérivation dans laquelle s'est produit le défaut.

Pour permettre de calculer les composantes résistive et capacitive de l'impédance de fuite dans une dérivation, le localisateur 2 doit connaître les valeurs réelle et imaginaire correspondantes (c'est à dire prises selon les mêmes axes de référence) de la tension aux bornes du défaut. Le localisateur 2 utilise directement, pour le calcul des composantes de la ou des impédances de fuite dans la ou les dérivations, les données démodulées de la tension d'injection Ui qui ont été préalablement calculées, par mesure et par démodulation synchrone, dans le contrôleur d'isolement global C.I. Dans ce but, deux liaisons de télétransmission distinctes sont prévues entre le contrôleur d'isolement C.I et le localisateur 2:

- une première liaison 3, qui est nécessairement une liaison de type synchrone, et qui transmet des impulsions fixes de synchronisation de la sinusoïde de référence élaborée par le contrôleur d'isolement C.I.

- une seconde liaison 4, qui peut être une liaison asynchrone, et qui transmet au localisateur 2 les valeurs démodulées de la tension d'injection Ui qui sont établies par le contrôleur C.I.

A noter que cette mise en phase, ou synchronisation, des deux sinusoïdes de référence respectivement élaborées par le contrôleur C.I et le localisateur 2 est indispensable à la détermination des composantes des impédances locales de fuite, puisque cette détermination nécessite la connaissance des composantes réelle et imaginaire de la tension et du courant aux bornes de chaque impédance de fuite, ces composantes étant nécessairement déterminées par rapport aux mêmes axes de référence.

Il ressort de ce qui précède que, aussi bien dans le contrôleur global d'isolement C.I, que dans le localisateur 2, s'effectue, sur différentes grandeurs de mesure, toujours un même traitement, qui comprend essentiellement des fonctions d'amplification du signal analogique de mesure, de filtrage passe-bas du courant à fréquence secteur (50 ou 60 hertz), d'acquisition numérique, avec filtrage passe-bas anti-repliement préalable et en pratique commun au filtrage de la fréquence secteur, et traitement numérique proprement dit, avec démodulation ou détection synchrone.

En conséquence, le localisateur 2 et le contrôleur global d'isolement C.I. utilisent chacun une seule chaîne de traitement, qui est assortie, de manière à exécuter les diverses fonctions qui lui sont demandées,d'un dispositif de commutation ou multiplexage utilisant par exemple des interrupteurs statiques.

Cette façon de faire, si elle est très avantageuse du point de vue économique, présente néanmoins deux inconvénients.

Un premier inconvénient est une conséquence du fait que la chaîne d'acquisition est soumise à des échelons brusques au moment de l'établissement des divers phénomènes de mesure, c'est à dire au moment de la fermeture ou de l'ouverture des interrupteurs statiques précités, qu'il s'agisse de mesures de courants, de tensions, de déphasages, de résistances, ou autres. Le filtre anti-repliement généralement utilisé ne répond pas instantanément aux échelons qui lui sont appliqués, et sa sortie présente un nombre de suroscillations qui, si l'on tient compte du fait que l'amplitude tolérable d'une suroscillation doit être inférieure à celle qui correspond au "bit" de quantification, ou "L.S.B", du convertisseur analogique/numérique utilisé, est loin d'être négligeable. Pendant toute la durée de ces suroscillations de changement d'état, la chaîne numérique de traitement ne peut pas fonctionner correctement.

Le livre "U. TIETZE, CH. SCHENK" Halbleiter-Schaltungstechnik" 1986, Springer, Berlin p. 376-381 et 390-405 se rapporte à un filtre passe-bas ayant un coefficent de surtension de 0,5, mais il subsiste néanmoins des suroscillations.

Un autre inconvénient réside dans le fait qu'afin de pouvoir utiliser, avec le nombre de bits souhaité, le même convertisseur analogique/numérique pour toutes ces données qui peuvent être d'amplitudes très diverses, il est nécessaire de faire précéder le convertisseur analogique/numérique d'un amplificateur opérationnel de gain réglable en fonction de l'amplitude du signal d'entrée. Or, il est bien connu que le gain G d'un amplificateur opérationnel est lié à sa bande passante B par une relation de la forme:

$$G \times B = \text{Constante.}$$

La variation du gain G provoque la variation de la bande passante et étant donné qu'un amplificateur opérationnel est en réalité un filtre actif passe-bas, le déphasage introduit varie également. Or, le traitement par démodulation synchrome exige, pour être exact, un déphasage préférentiellement constant. On aboutit par suite à une impossibilité pratique de fonctionnement correct du dispositif de contrôle d'isolement, sauf à rajouter des équipements complexes et nécessairement coûteux.

Le document EP-A-74235 décrit un analyseur de signal analytique programmable comportant un atténuateur automatique en fonction du signal.

L'invention vise à rémédier à ces inconvénients. Elle se rapporte à une chaîne de traitement de grandeurs de mesure selon la revendication 1.

De toute façon, l'invention sera bien comprise, et ses avantages et autres caractéristiques ressortiront, lors de la description suivante d'un exemple non limitatif de réalisation, en référence au dessin schématique annexé dans lequel:

La figure 2 est un schéma synoptique d'ensemble de la chaîne.

La figure 3 est un schéma d'un filtre anti-repliement qui peut être utilisé dans la chaîne; et

La figure 4 est un schéma du dispositif d'amplification réglable qui est placé à l'entrée de son convertisseur analogique/numérique.

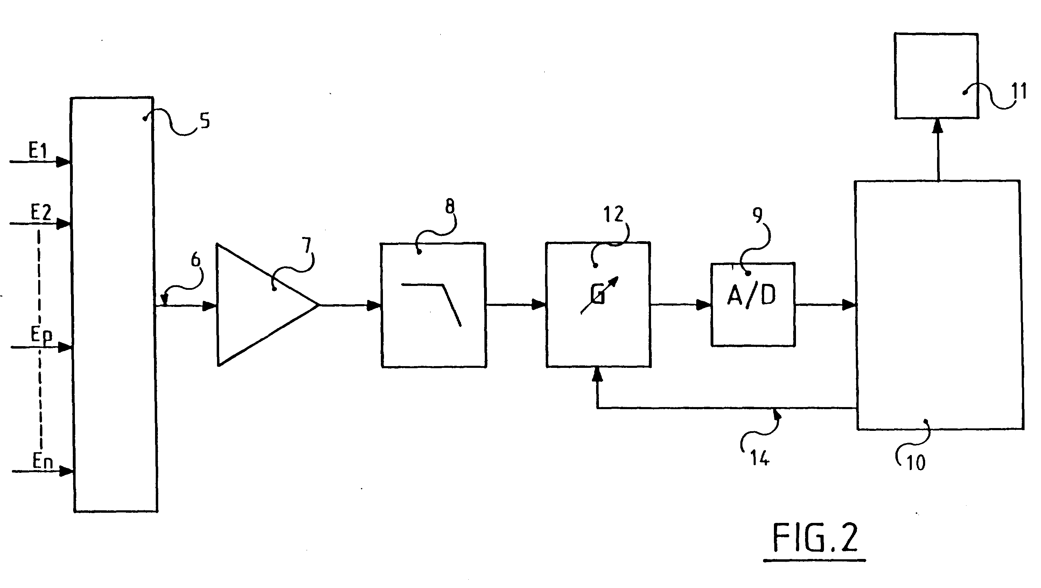

En se référant à la figure 2, la chaîne de traitement de grandeurs de mesure pour contrôleur d'isolement numérique à détection ou démodulation synchrone est précèdée d'un dispositif de multiplexage 5 à n entrées E1,E2,...,Ep,...En, recevant chacune une des grandeurs analogiques de mesure à traîter par démodulation synchrone, et bien-entendu une seule sortie 6.

Le multiplexeur 5 est suivi d'un préamplificateur 7 de mise à niveau, lui-même suivi d'un filtre passe-bas 8 dont la fréquence de coupure est inférieure à la fréquence à 50 Hertz du réseau, tout en étant supérieure à la fréquence d'injection. Le filtre 8 pour le 50 Hertz joue également le rôle de filtre anti-repliement pour l'organe d'acquisition numérique que constitue le convertisseur analogique/numérique 9 qui est placé en aval du filtre 9 et à l'entrée du processeur 10 qui réalise toute la partie numérique du traitement.

Le processeur 10 est relié à un organe 11 apte à afficher les données démodulées et calculées par le microprocesseur.

Entre le filtre 8 et le convertisseur analogique/numérique 9 est en outre prévu un organe d'amplification 12 dont le gain est automatiquement ajusté par le processeur 10, via une liaison 14, de façon à obtenir une tension d'amplitude optimale à l'entrée du convertisseur 9.

Conformément à l'invention, et afin d'éviter des suroscillations à chaque commutation d'une entrée du multiplexeur 5 sur l'autre, le filtre antirepliement 8 est un filtre apériodique à pôles réels, dont les composants sont calculés pour lui conférer un coefficient de surtension inférieur ou égal à 0,5.

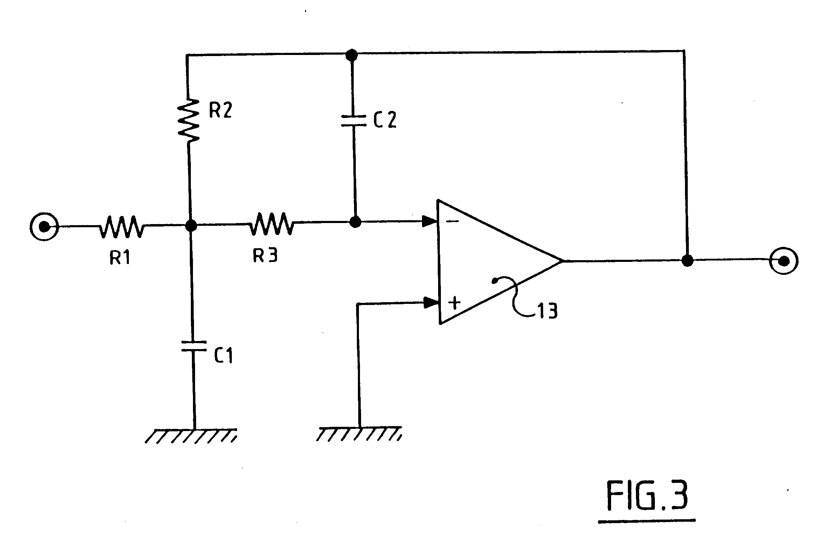

Par exemple, il est possible d'utiliser, pour la réalisation du filtre 8, la structure classique de RAUCH qui est schématisée sur le figure 3, mais comportant un amplificateur opérationnel 13 et des composants résistifs R1,R2,R3, et capacitifs C1,C2 dont les valeurs sont déterminées pour conférer au filtre actif un coefficient de surtension égal à 0,5.

Par exemple, les composants résistifs et capacitifs ont les valeurs suivantes:

R1 = 47500 Ohms
R2 = 47500 Ohms
R3 = 44200 Ohms
C1 = 330 nanofarads
C2 = 150 nanofarads

Avec un filtre de ce type, aucune fréquence d'oscillations n'est générée en sortie du filtre lorsqu'on applique un échelon de tension sur son entrée.

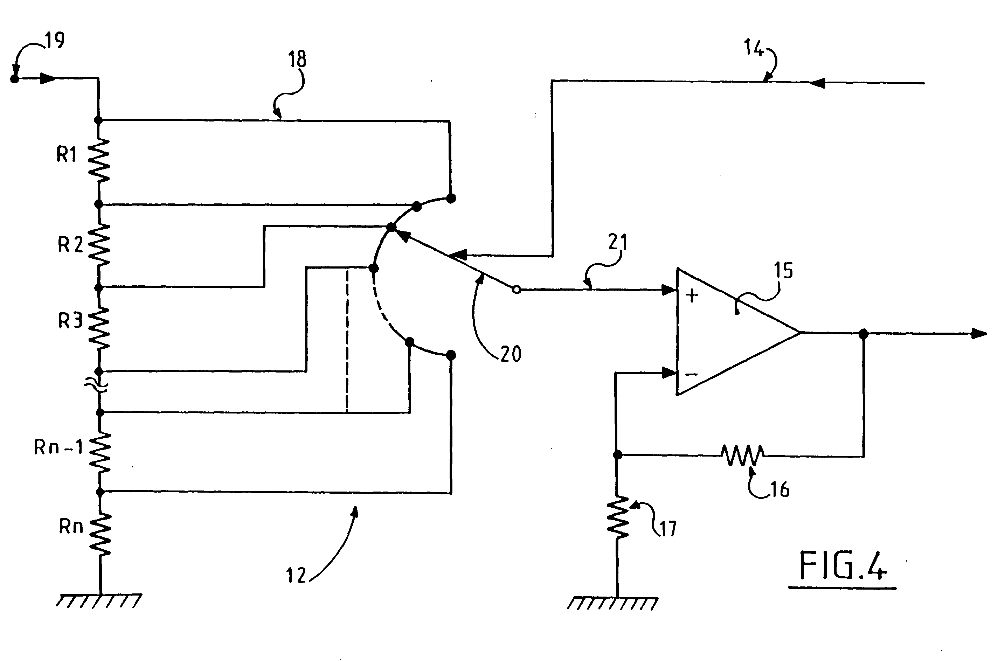

Selon un autre aspect de l'invention, l'organe d'amplification réglable 12, commandé par la liaison 14, comporte, tel que représenté sur la figure 4:

- un amplificateur opérationnel 15 dont le gain est fixé par ses deux résistances de contre-réaction 16 et 17; et

- un atténuateur réglable 18 à montage potentiométrique, qui est placé juste en amont de l'amplificateur 15.

L'atténuateur 18 comporte un pont de résistances passives R1,R2,R3,...,Rn-1,Rn, qui sont disposées en cascade entre l'entrée 19 du circuit d'amplification réglable et la masse.

Un commutateur 20, symbolisé ici par un sélecteur rotatif, permet, sous commande du processeur 10 via la liaison 14, de relier soit la totalité de la cascade de résistances, soit seulement une fraction de celle-ci à l'entrée 21 de l'amplificateur à gain fixe 15.

Dans le cas de faibles signaux, la totalité de la cascade est sélectionnée, de sorte que ces signaux sont appliqués, sans risques de distorsions ou autres, directement sur l'entrée 21 de l'amplificateur 15. Pour des signaux d'amplitudes croissantes, le curseur du commutateur 20 se déplace progressivement dans le sens anti-horaire, engendrant une atténuation linéaire, et progressant par pas, de la tension qui est appliquée sur la borne 19. Le gain de l'amplificateur 15 étant constant, et l'atténuateur 18 n'utilisant que des résistances pures, le circuit 12 n'introduit aucun déphasage, ce qui est le but recherché pour l'organe à amplification réglable.

Comme il va de soi, l'invention n'est pas limitée à l'exemple de réalisation qui vient d'être décrit. C'est ainsi par exemple qu'un autre type de filtre qu'une structure de RAUCH peut aussi bien être utilisée, pourvu que ses composants soient calculés pour lui conférer un coefficient de surtension inférieur ou égal à 0,5.

**Revendications**

1. Chaîne de traitement de grandeurs de mesure pour un contrôleur d'isolement numérique, qui comprend

- un contrôleur d'isolement (CI) pour injecter dans le réseau électrique une tension alternative de référence ayant une fréquence inférieure à celle du courant alternatif du réseau et pour générer une sinusoïde et une cosinusoïde auxiliaires

- un dispositif de commutation (5) précédant ladite chaîne destiné à traiter séparément des grandeurs de mesure (E1,E2,Ep,En), ladite chaîne comportant:

- un filtre anti-repliement (8),

- un dispositif (12) d'amplification réglable, précédant un organe (9) d'acquisition numérique,

- et un organe central (10) de traitement numérique qui réalise une démodulation ou détection synchrone pour la détermination des composantes résistives et capacitives desdites grandeurs,

caractérisé en ce que :

- le filtre anti-repliement (8) est un filtre apériodique à pôles réels dont les composants (R1,R2,R3,C1,C2) sont calculés pour lui conférer un coefficient de surtension inférieur ou égal à 0,5,

- le dispositif d'amplification réglable (12) comporte un amplificateur opérationnel (15) de gain fixe associé à un atténuateur réglable (18), lequel est connecté au moyen d'une liaison (14) électrique à l'organe central (10) de traitement qui ajuste le gain du dispositif (12) d'amplification pour obtenir une tension d'amplitude optimale à l'entrée de l'organe (9) d'acquisition numérique,

- et l'atténuateur (18) comporte un pont de résistances passives (R1, R2, R3... Rn1, Rn),et un commutateur (20) commandé par les signaux en provenance de l'organe central (10) de traitement pour assurer une sélection prédéterminée des résistances en fonction du niveau des signaux de sortie du filtre anti-repliement (8).

**Patentansprüche**

1. Meßgrößen-Verarbeitungsschaltung für einen digitalen Isolationswächter, bestehend aus

- einem Isolationswächter (C.I.) zur Injizierung einer Referenz-Wechselspannung mit einer unter der Frequenz des Netz-Wechselstroms liegenden Frequenz in das elektrische Leitungsnetz sowie zur Erzeugung eines Sinus- und eines Kosinus-Hilfssignals,
- einer der genannten Schaltung vorgeschalteten Umschaltvorrichtung (5) zur getrennten Verarbeitung der Meßgrößen (E1, E2, Ep, En), wobei die genannte Schaltung
- ein Anti-Aliasing-Filter (8),
- ein, einem digitalen Erfassungsglied (9) vorgeschaltetes, einstellbares Verstärkerglied (12) sowie
- ein zentrales Glied (10) zur digitalen Verarbeitung umfaßt, das eine synchrone Demodulation bzw. Erfassung zur Bestimmung der Wirkanteile und der kapazitiven Blindanteile der genannten Größen vornimmt,

dadurch gekennzeichnet, daß

- das Anti-Aliasing-Filter (8) als aperiodisches Filter mit reellen Polen ausgeführt ist, dessen Komponenten (R1, R2, R3, C1, C2) so berechnet werden, daß er eine Welligkeit von $\leq$ 0,5 aufweist,
- das einstellbare Verstärkerglied (12) einen Operationsverstärker (15) mit festem Verstärkungsfaktor umfaßt, der einem einstellbaren Dämpfungsglied (18) zugeordnet ist, welches über eine Elektrische Verbindung (14) an das zentrale Verarbeitungsglied (10) angeschlossen ist, das den Verstärkungsfaktor des Verstärkerglieds (12) anpaßt, um eine Spannung mit optimaler Amplitude am Eingang des digitalen Erfassungsglieds (9) zu erhalten, und
- das Dämpfungsglied (18) eine Brückenschaltung aus passiven Widerständen (R1, R2, R3... Rn-1, Rn) sowie einen Umschalter (20) umfaßt, der über die vom zentralen Verarbeitungsglied (10) stammenden Signale angesteuert wird, um die Aufschaltung einer bestimmten Anzahl von Widerständen in Abhängigkeit vom Pegel der Ausgangssignale des Anti-Aliasing-Filters (8) zu gewährleisten.

## Claims

1. A channel for processing measured quantities for a digital isolation monitor which comprises :

- an isolation monitor (C.I.) to input to the electrical power system a reference AC voltage having a frequency lower than that of the alternating current of the power system, and to generate an auxiliary sine wave and cosine wave,

- a switching device (5) preceding said channel designed to process measured quantities (E1, E2, Ep, En) separately,

said channel comprising :

- an aliasing filter (8),
- an adjustable amplification device (12), preceding a digital acquisition unit (9),
- and a central digital processing unit (10) which performs synchronous demodulation or detection for determining the resistive and capacitive components of said quantities

characterized in that :

- the aliasing filter (8) is an aperiodic filter with real poles whose components (R1, R2, R3, C1, C2) are calculated so as to give it an overvoltage coefficient lower than or equal to 0.5,
- the adjustable amplification device (12) comprises a fixed gain operational amplifier (15) associated to an adjustable attenuator (18), which is connected by means of an electrical connecting line (14) to the central digital processing unit (10) which adjusts the gain of the amplification device (12) to obtain a voltage of optimum amplitude at the input of the digital acquisition unit (9),
- and the attenuator (18) comprises a bridge of passive resistances (R1, R2, R3 Rn-1, Rn), and a selector switch (20) controlled by the signals provided by the central processing unit (10) to perform preset selection of the resistances according to the level of the output signals from the aliasing filter (8).

FIG.1

FIG.2

EP 0 515 291 B1

FIG.3

EP 0 515 291 B1

FIG.4

EP 0 515 291 B1